# EUROPEAN PATENT APPLICATION

(11) **EP 3 926 070 A1**
(43) Date of publication of application: **22.12.2021**
(21) Application number: 19915404.8
(22) Date of filing: 26.11.2019
(51) Int. Cl.: C23C 14/50, C23C 16/458

(54) **UNIT FOR ROTATING WORKPIECE RETAINING PART, AND VACUUM PROCESSING DEVICE**

(30) Priority: 14.02.2019 JP 2019024034
(71) Applicant: Towa Corporation, Kyoto-shi, Kyoto 601-8105 (JP)
(72) Inventor: TAKADA,Naoki, Kyoto-shi, Kyoto 601-8105 (JP); TAKEUCHI,Shin, Kyoto-shi, Kyoto 601-8105 (JP); ARAKI,Kosuke, Kyoto-shi, Kyoto 601-8105 (JP); HIGASHI,Daisuke, Kyoto-shi, Kyoto 601-8105 (JP); MORIYAMA,Kazuo, Kyoto-shi, Kyoto 601-8105 (JP); SHIMIZU,Yuki, Kyoto-shi, Kyoto 601-8105 (JP)
(74) Representative: Becker, Eberhard
(86) International application number: PCT/JP2019/046044
(87) International publication number: WO 2020/166168

(57) **Abstract**

Provided is a unit for rotating a workpiece retaining part, whereby it is possible to respond to angle dependency in vacuum processing. The present invention is provided with: a rotating shaft 20; a rotating wheel 40 capable of rotating about the rotating shaft 20; a plurality of workpiece retaining parts 60 which is capable of retaining a workpiece W, is arranged to be aligned on a periphery centered on the rotating shaft 20, and is provided on the rotating wheel 40 to be able to rotate about an axis inclined with respect to an axis of the rotating shaft 20; and a fixed disk 70 which is formed in a disk shape centered on the rotating shaft 20, is arranged in contact with the plurality of workpiece retaining parts 60, and causes the workpiece retaining parts 60 to rotate in accordance with rotation of the rotating wheel 40.

## Description

### [Technical Field]

The present invention relates to a technique of a unit for rotating a workpiece retaining part and a vacuum processing device.

### [Background Art]

Techniques of a unit for rotating a workpiece retaining part and a vacuum processing device in the related art are as described in, for example, Patent Literature 1.

Patent Literature 1 discloses a coating device that performs coating while rotating a small-diameter tool. This coating device includes a rotation jig which is capable of retaining a small-diameter tool and is capable of being rotated (on its axis), a small-revolution jig that rotates (small revolution) the rotation jig about a small-revolution axis, and a large-revolution jig that rotates (large revolution) the small-revolution jig about a large-revolution axis. The axes (rotation center lines) of the rotation jig, the small-revolution jig, and the large-revolution jig are arranged to be parallel to each other. In addition, a target is disposed on a lateral side of this large-revolution jig or the like.

In the coating device configured in this way, the small-diameter tool is coated with a material emitted from the target while the small-diameter tool is rotated on its axis and undergoes small revolution and large revolution. By performing such rotation on its axis and revolution, the entire surface of the small-diameter tool can be coated.

However, in the technique described in Patent Document 1, in a case in which the small-diameter tool is rotated (rotated on its axis and revolved (small revolution and large revolution)), a side surface of the small-diameter tool faces the target, but an upper surface thereof does not face the target. Therefore, there is room for improvement in that the coating may be uneven between the side surface and the upper surface of the small-diameter tool.

For example, in a sputtering method, a film quality of a formed film may vary depending on an angle at which particles of a film forming material emitted from a sputtering target reach a workpiece. Further, not only in film forming devices such as a dry etching device and a surface modifying device, but even in a plasma processing device, processing characteristics or processing performance may vary depending on an angle at which plasma reaches the workpiece. There is a demand for a technique capable of responding to angle dependency in such vacuum processing.

### [Citation List]

### [Patent Literature]

### [Patent Literature 1]

Japanese Unexamined Patent Application Publication No. 2007-77469

### SUMMARY

### [Technical Problem]

The present invention has been made in view of the above circumstances, and an objective of the present invention is to provide a unit for rotating a workpiece retaining part, whereby it is possible to respond to angle dependency in vacuum processing, and a vacuum processing device.

### [Solution to Problem]

The objective of the present invention is as described above, and to attain the objective, a unit for rotating a workpiece retaining part according to the present invention includes a rotating shaft; a rotating part capable of rotating about the rotating shaft; a plurality of workpiece retaining parts which is capable of retaining a workpiece, is arranged to be aligned on a periphery centered on the rotating shaft, and is provided on the rotating part to be able to rotate about an axis inclined with respect to an axis of the rotating shaft; and a rotationally driving part which is formed in a disk shape centered on the rotating shaft, is arranged in contact with the plurality of workpiece retaining parts, and causes the workpiece retaining parts to rotate in accordance with rotation of the rotating part.

Further, a vacuum processing device according to the present invention includes the unit for rotating a workpiece retaining part.

### [Advantageous Effects of Invention]

According to the present invention, it is possible to respond to angle dependency in vacuum processing.

### BRIEF DESCRIPTION OF THE DRAWINGS

Fig. 1 is a schematic cross-sectional view along line A-A, showing a schematic configuration of a sputtering device.
Fig. 2 is likewise a schematic plan cross-sectional view.
Fig. 3 is a front cross-sectional view showing an internal structure of a film forming chamber.
Fig. 4 is an enlarged front cross-sectional view showing an internal structure of a film forming chamber.
Fig. 5 is a front cross-sectional view showing a periphery of a workpiece retaining part.
Fig. 6 is a plan view showing a configuration of a rotating wheel.
Fig. 7 is a plan view showing a configuration of a fixed disk and a restricting part.
Fig. 8 is a diagram showing each process of a method for manufacturing a film-formed product.
Fig. 9 (a) is a schematic view showing an aspect in which film forming processing is performed in a state where a workpiece is not inclined. Fig. 9 (b) is a schematic view showing an aspect in which film forming processing is performed in a state where a workpiece is inclined.
Fig. 10 is a diagram showing an example of evaluation regarding a life of a tool of the present application.
Fig. 11 is a diagram showing an example of evaluation regarding occurrence of a chip in the tool of the present application.

### DESCRIPTION OF THE EMBODIMENTS

In the following, explanation will be performed with directions indicated by an arrow U, an arrow D, an arrow L, an arrow R, an arrow F, and an arrow B in the drawings defined as an upward direction, a downward direction, a leftward direction, a rightward direction, a forward direction, and a backward direction, respectively.

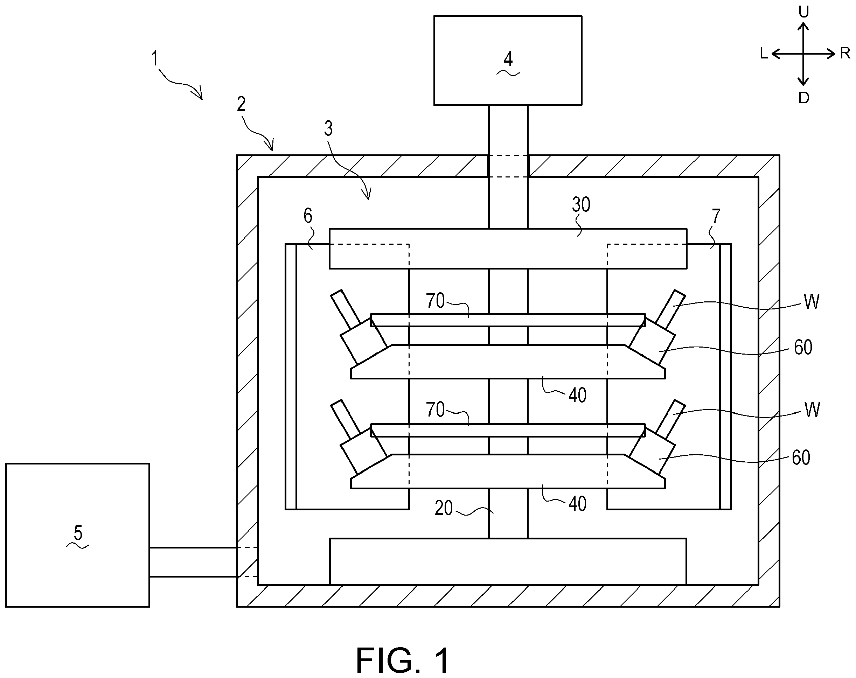

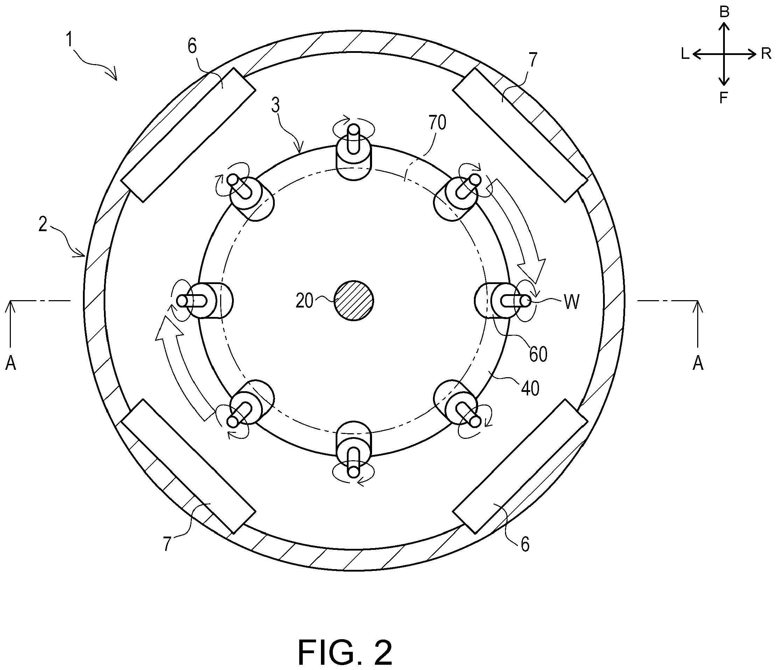

Hereinafter, an outline of a sputtering device 1 according to the present embodiment will be described with reference to Figs. 1 and 2.

The sputtering device 1 is a vacuum processing device (a vacuum film forming device) that performs film forming processing in a vacuum. In the sputtering device 1 according to the present embodiment, a machining tool is assumed as a workpiece (a product to be processed) W on which film forming processing is performed. The sputtering device 1 mainly includes a film forming chamber 2, a unit for rotating a workpiece retaining part 3, a motor 4, an exhaust device 5, a target (a sputtering target) 6, and a heater 7.

The film forming chamber 2 forms a space for performing the film forming processing on the workpiece W. The film forming chamber 2 is formed in a substantially columnar shape with its axis oriented in an up-and-down direction (see Fig. 2). The film forming chamber 2 is formed in a hollow shape.

The unit for rotating a workpiece retaining part 3 rotates a workpiece retaining part 60, which will be described later. The unit for rotating a workpiece retaining part 3 is arranged in the film forming chamber 2.

The motor 4 (see Fig. 1) is a drive source for rotationally driving the unit for rotating a workpiece retaining part 3. The motor 4 is arranged outside the film forming chamber 2. Power of the motor 4 is transmitted to the unit for rotating a workpiece retaining part 3 via an appropriate power transmission mechanism (for example, a shaft or the like).

The exhaust device 5 (see Fig. 1) adjusts an inside of the film forming chamber 2, by discharging air in the film forming chamber 2, such that a degree of vacuum is suitable for the film forming processing.

The target 6 is a material (a film forming material) to be formed as a film on the workpiece W. The target 6 is formed in a flat plate shape. The target 6 is arranged in the film forming chamber 2. A pair of targets 6 is provided with the unit for rotating a workpiece retaining part 3 interposed therebetween. The target 6 is arranged such that a plate surface thereof is in the vertical direction. Further, the target 6 is arranged such that the plate surface faces a center of the film forming chamber 2 (that is, the unit for rotating a workpiece retaining part 3).

The heater 7 is for heating the workpiece W to improve film forming quality (uniformity and the like). The heater 7 is arranged in the film forming chamber 2. A pair of heaters 7 is provided with the unit for rotating a workpiece retaining part 3 interposed therebetween. The targets 6 and the heaters 7 are arranged at equal intervals around the unit for rotating a workpiece retaining part 3.

Next, the unit for rotating a workpiece retaining part 3 will be described more specifically.

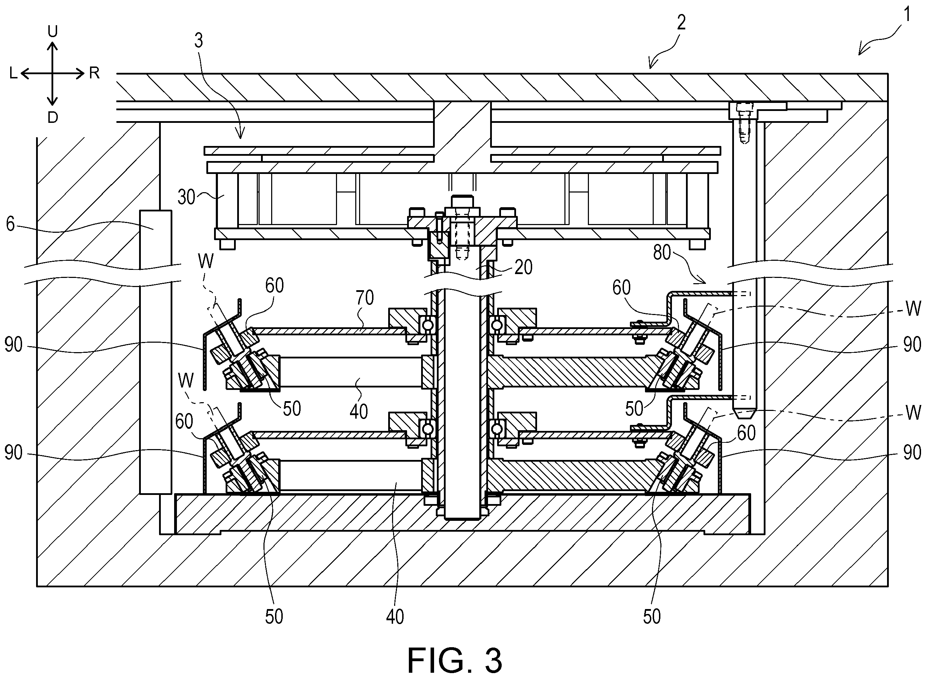

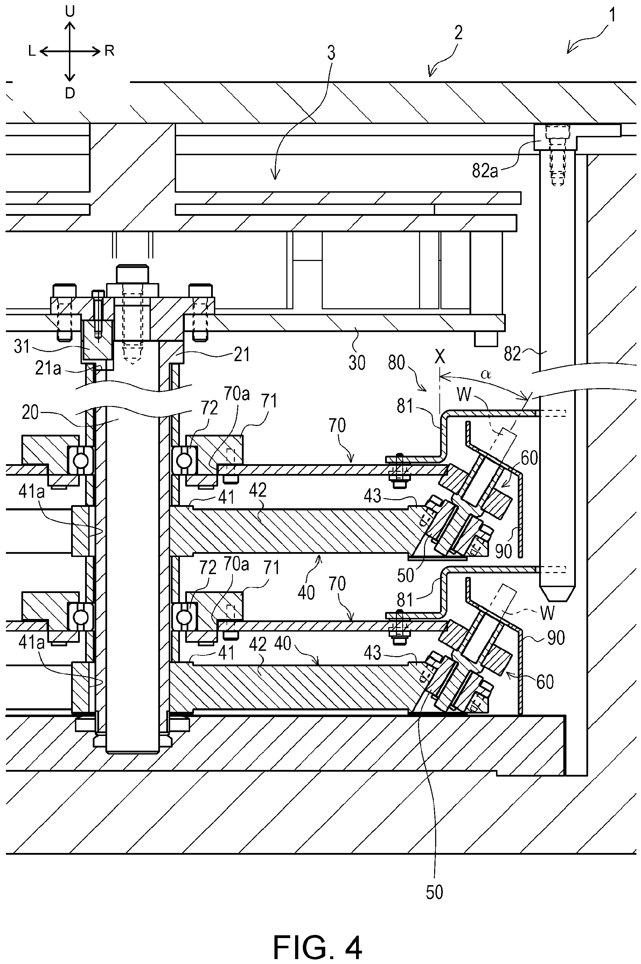

The unit for rotating a workpiece retaining part 3 shown in Figs. 3 and 4 mainly includes a rotating shaft 20, an upper rotating body 30, a rotating wheel 40, an attachment member 50, a workpiece retaining part 60, a fixed disk 70, a restricting part 80, and a cover 90.

The rotating shaft 20 is a center of rotation of the rotating wheel 40, which will be described later. The rotating shaft 20 is formed in a substantially columnar shape. The rotating shaft 20 is arranged with its axis oriented in the vertical direction (the up-and-down direction). An outer tube member 21 formed in a cylindrical shape to cover a side surface of the rotating shaft 20 is fitted to the rotating shaft 20 to be able to rotate integrally with the rotating shaft 20. A key groove 21a is formed at an upper end portion of the outer tube member 21.

The upper rotating body 30 is able to rotate integrally with the rotating shaft 20. The upper rotating body 30 is formed in a circular shape in a plan view. An upper end of the rotating shaft 20 is fixed to a center of a bottom surface of the upper rotating body 30. A key member 31 is fixed near the center of the bottom surface of the upper rotating body 30. By the key member 31 engaging with the key groove 21a of the outer tube member 21, relative rotation between the upper rotating body 30 and the rotating shaft 20 is restricted. That is, the upper rotating body 30 is able to rotate integrally with the rotating shaft 20. An upper portion of the upper rotating body 30 is rotatably supported on an upper surface of the film forming chamber 2. The power of the motor 4 (see Fig. 1) can be transmitted to the upper rotating body 30. The upper rotating body 30 can be rotated together with the rotating shaft 20 with the power from the motor 4.

The rotating wheel 40 shown in Figs. 3 to 6 rotates (revolves) the workpiece retaining part 60, which will be described later, about the rotating shaft 20. The rotating wheel 40 mainly includes a boss portion 41, a rib 42, and an outer peripheral portion 43.

The boss portion 41 is a portion formed at a center of the rotating wheel 40. The boss portion 41 is formed in a substantially cylindrical shape with its axis oriented in the vertical direction (the up-and-down direction). A through hole 41a is formed in a center of the boss portion 41 to vertically penetrate the boss portion 41.

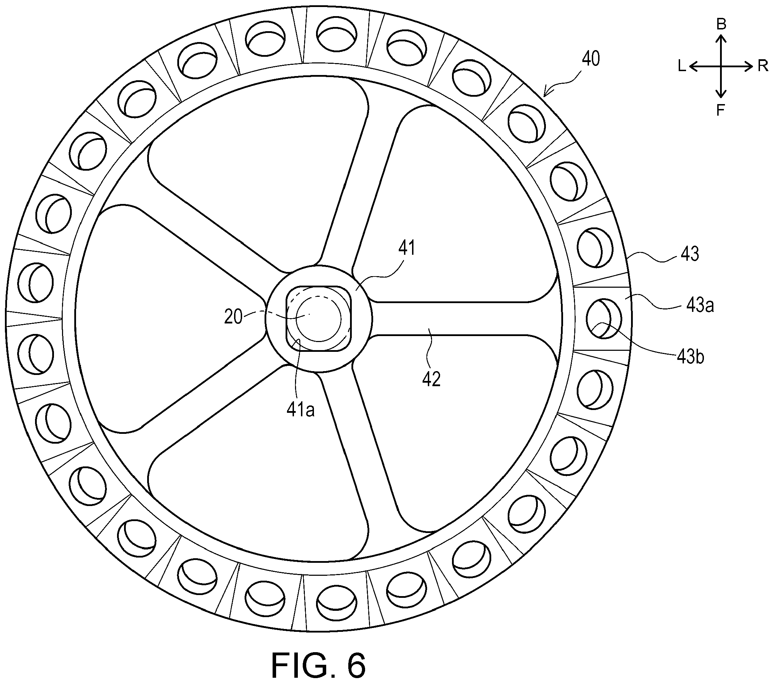

The rib 42 is a rod-shaped portion formed to extend from the boss portion 41 toward an outside of the boss portion 41 in a radial direction of the rotating wheel 40. A plurality of ribs 42 (five in the present embodiment) is formed around the boss portion 41 at equal intervals (see Fig. 6).

The outer peripheral portion 43 is a portion that supports the workpiece retaining part 60, which will be described later. The outer peripheral portion 43 is formed in an annular shape centered on the boss portion 41 in a plan view. The inner peripheral surface of the outer peripheral portion 43 is fixed to an outer end portion of the rib 42 in the radial direction of the rotating wheel 40. In this way, the outer peripheral portion 43 is connected to the boss portion 41 via the rib 42. In the present embodiment, the boss portion 41, the rib 42, and the outer peripheral portion 43 are integrally formed with each other. An inclined surface 43a and a through hole 43b are mainly formed in the outer peripheral portion 43.

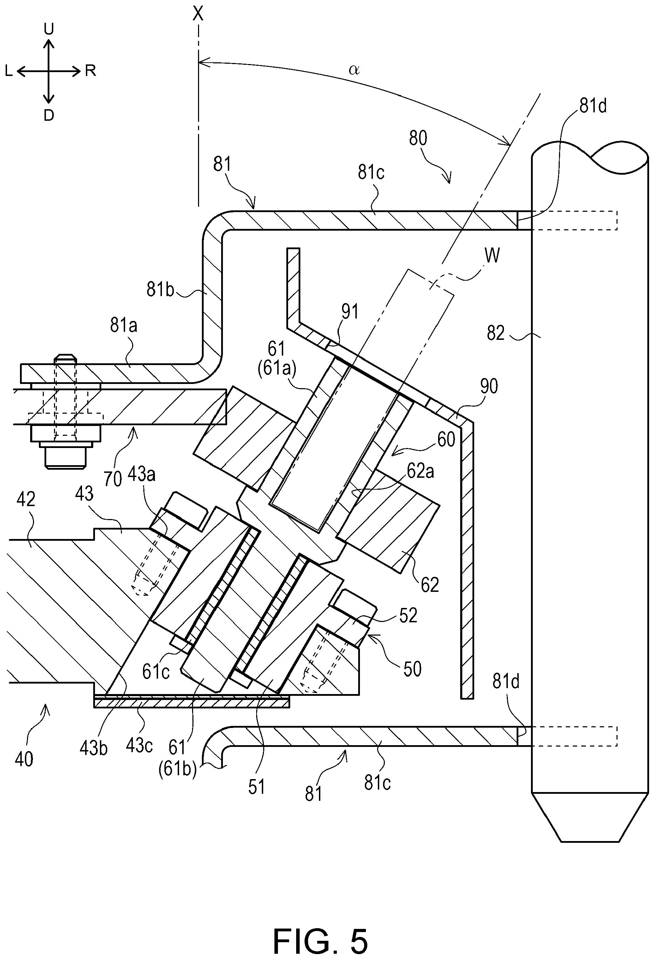

The inclined surface 43a shown in Figs. 5 and 6 is formed on an upper surface of the outer peripheral portion 43. The inclined surface 43a is formed to face in a direction inclined with respect to the up-and-down direction (an axial direction of the rotating shaft 20). Specifically, the inclined surface 43a is formed to incline downward as it goes outward in the radial direction of the rotating wheel 40.

The through hole 43b is formed to vertically penetrate the outer peripheral portion 43. An upper end of the through hole 43b is formed to be open toward the inclined surface 43a. The through hole 43b is formed to extend perpendicularly to the inclined surface 43a. That is, the through hole 43b is formed to extend in a direction inclined with respect to the vertical direction (the up-and-down direction). More specifically, the through hole 43b is formed to extend outward in the radial direction of the rotating wheel 40 as it goes upward. A lower end (an opening on a lower side) of the through hole 43b is closed by a plate-shaped closing member 43c.

As shown in Fig. 6, a plurality of inclined surfaces 43a and a plurality of through holes 43b are formed at equal intervals in a circumferential direction of the outer peripheral portion 43.

As shown in Fig. 4, the rotating wheel 40 is provided on the rotating shaft 20 (the outer tube member 21). Specifically, the rotating shaft 20 is inserted through the boss portion 41 (the through hole 41a) of the rotating wheel 40. At this time, the rotating wheel 40 and the rotating shaft 20 engage with each other to be able to rotate integrally with each other. Further, the rotating shaft 20 is provided with a plurality of rotating wheels 40 aligned vertically at equal intervals. In Figs. 1, 3 and 4, two rotating wheels 40 are illustrated as an example.

The attachment member 50 shown in Figs. 4 and 5 is for attaching the workpiece retaining part 60, which will be described later, to the rotating wheel 40. The attachment member 50 mainly includes a main body portion 51 and a flange portion 52.

The main body portion 51 is a portion formed in a cylindrical shape. An outer diameter of the main body portion 51 is formed to be substantially the same as an inner diameter of the through hole 43b of the rotating wheel 40.

The flange portion 52 is a disk shaped portion formed with a diameter that expands from the vicinity of an upper end portion of the main body portion 51.

The main body portion 51 is inserted into the through hole 43b of the rotating wheel 40 from above. The flange portion 52 is fixed to the inclined surface 43a of the rotating wheel 40 with an appropriate fastening member (a bolt or the like). In this way, the attachment member 50 is provided in each through hole 43b of the rotating wheel 40. An axis of the attachment member 50 (the main body portion 51) is arranged to be inclined at the same angle as the through hole 43b.

The workpiece retaining part 60 retains the workpiece W such that the workpiece W is able to rotate (on its axis). The workpiece retaining part 60 mainly includes a rotation support part 61 and a rotationally driven part 62.

The rotation support part 61 retains the workpiece W. The rotation support part 61 mainly includes a retaining part 61a and a support part 61b.

The retaining part 61a is a portion that retains the workpiece W. The retaining part 61a is formed in a substantially cylindrical shape (a bottomed tubular shape) having a bottom surface (a lower surface). An upper portion of the retaining part 61a is open, and the workpiece W inserted through this opening can be retained in the retaining part 61a. The retaining part 61a can not only directly retain the workpiece W, but can also retain the workpiece W via an appropriate member (such as a cap that retains the workpiece W).

The support part 61b is a portion supported by the rotating wheel 40 via the attachment member 50. The support part 61b is formed in a substantially columnar shape. An outer diameter of the support part 61b is formed to be smaller than an inner diameter of the attachment member 50. The support part 61b is formed to protrude downward from the bottom surface of the retaining part 61a. The support part 61b and the retaining part 61a are formed on the same axis.

The support portion 61b is inserted into the main body portion 51 of the attachment member 50 from above. The support portion 61b is rotatably supported by the attachment member 50 (the main body portion 51) via an appropriate bearing member 61c. By the support part 61b being inserted into the main body portion 51, the retaining part 61a is arranged to protrude upward from the rotating wheel 40. An axis of the rotation support part 61 is arranged to be inclined at the same angle as the axis of the attachment member 50 (the main body portion 51). In other words, as shown in Fig. 1, the rotation support part 61 is arranged to be inclined with respect to the plate surface of the target 6 arranged on a lateral side. The rotation support part 61 can rotate (on its axis) about an axis inclined with respect to the axis (the up-and-down direction) of the rotating shaft 20.

Any member can be used as the bearing member 61c. For example, any member such as a ball bearing or a slide bearing can be appropriately selected. Further, it is also possible to provide a plurality of bearing members 61c for one support part 61b.

Further, it is possible to arbitrarily set an inclination angle of the axis of the support part 61b (an inclination angle α (see Fig. 5), which will be described later). For example, it is possible to set the inclination angel of the axis of the support part 61b such that the support part 61b is inclined 20° to 80° with respect to the rotating shaft 20 or the target 6 (with the vertical direction as a reference).

The rotationally driven part 62 is a portion that is in contact with the fixed disk 70, which will be described later. The rotationally driven part 62 is formed in a substantially circular flat plate shape as seen in an axial direction of the rotation support part 61. A through hole 62a is formed at a center of the rotationally driven part 62. The through hole 62a of the rotationally driven part 62 is fitted to the retaining part 61a of the rotation support part 61 above the rotating wheel 40. As a result, the rotationally driven part 62 is able to rotate integrally with the rotation support part 61.

In this way, the workpiece retaining part 60 is provided on the outer peripheral portion 43 of the rotating wheel 40 via the attachment member 50. Further, a plurality of workpiece retaining parts 60 is provided to be aligned along the outer peripheral portion 43 (that is, on a periphery centered on the rotating shaft 20).

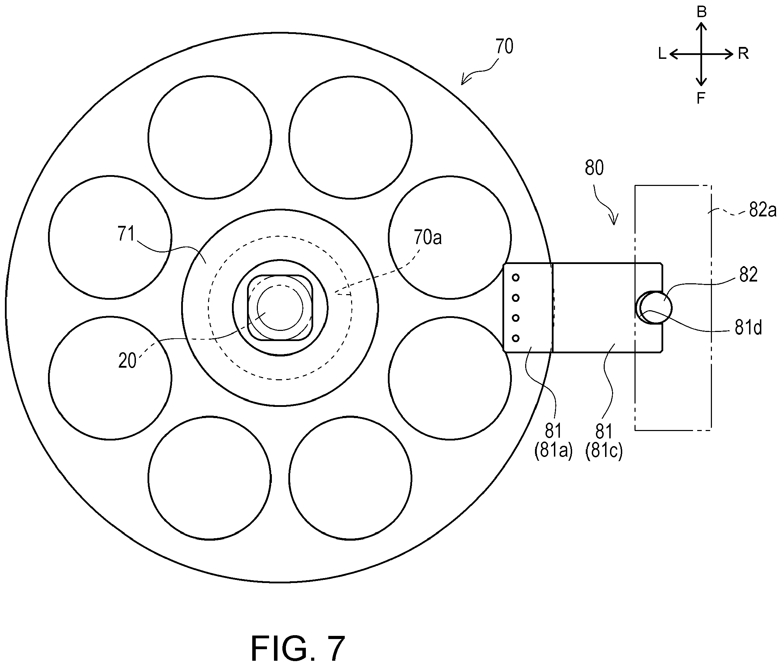

The fixed disk 70 shown in Figs. 3 to 5 and 7 is for rotating the workpiece retaining part 60. The fixed disk 70 is formed in a circular plate shape (a disk shape) in a plan view. A through hole 70a is formed in a center of the fixed disk 70.

As shown in Fig. 4, the fixed disk 70 is provided on the rotating shaft 20 via a fixing member 71 and a bearing member 72. Specifically, an outer ring of the bearing member 72 is fixed to the inside (the through hole 70a) of the fixed disk 70 via the fixing member 71. The rotating shaft 20 is inserted through an inner ring of the bearing member 72 and the inner ring is fixed to the rotating shaft 20. In this way, the fixed disk 70 is provided to be able to relatively rotate on the rotating shaft 20 via the bearing member 72. The fixed disk 70 is provided above the rotary wheel 40 at an appropriate distance from the rotating wheel 40. That is, fixed disks 70 equal in number to the rotating wheels 40 are provided to correspond to the rotating wheels 40. An outer peripheral end portion of the fixed disk 70 is arranged in contact with the rotationally driven part 62 of the workpiece retaining part 60 provided on the corresponding rotating wheel 40.

Any member can be used as the bearing member 72. For example, any member such as a ball bearing, a roller bearing, or a slide bearing can be appropriately selected.

The fixed disk 70 and the rotationally driven part 62 are configured such that, by the workpiece retaining part 60 rotating (revolving) about the rotating shaft 20, power for rotating the work holding unit 60 on its axis is transmitted to the workpiece retaining part 60. For example, the fixed disk 70 and the rotationally driven part 62 can be formed of a gear having teeth that mesh with each other (for example, a bevel gear). As a result, the fixed disk 70 can continuously rotate (on its axis) the workpiece retaining part 60 (in particular, continuously rotate the workpiece W in a state where the workpiece W is facing the target 6). In addition, the fixed disk 70 and the rotationally driven part 62 may be configured to be able to come in contact with each other and to transmit power. For example, a configuration in which power is transmitted using a meshing structure such as a combination of a gear, a chain, and a sprocket, a combination of a hole and a protrusion, a configuration in which power is transmitted using a frictional force between contact surfaces, and the like may be used.

Further, the fixed disk 70 and the rotationally driven part 62 may be in contact with each other via an inclusion that does not include a mechanical mechanism. In this case, the fixed disk 70, which is a rotating part, and the rotationally driven part 62, which is a part of the workpiece retaining part 60, are in contact with each other without an intervening mechanical mechanism.

Further, the fixed disk 70 and the rotationally driven part 62 are not limited to those that continuously transmit power and continuously rotate the workpiece retaining part 60 like gears. For example, the fixed disk 70 and the rotationally driven part 62 can intermittently rotate the workpiece retaining part 60 (on its axis) by intermittently transmitting power using a cam or the like.

The restricting part 80 restricts the rotation of the fixed disk 70. The restricting part 80 mainly includes a first restricting member 81 and a second restricting member 82.

The first restricting member 81 is fixed to each fixed disk 70. The first restricting member 81 is formed by a rectangular plate member being bent. Specifically, the first restricting member 81 includes a left portion 81a extending horizontally, a halfway portion 81b extending vertically upward from a right end of the left portion 81a, and a right portion 81c extending rightward from an upper end of the halfway portion 81b. As described above, the first restricting member 81 is formed such that an outer portion (the right portion 81c) in the radial direction of the fixed disk 70 is higher than an inner portion (the left portion 81a) in the radial direction of the fixed disk 70. As a result, it is possible to avoid interference with the workpiece retaining part 60 or the workpiece W.

The left portion 81a of the first restricting member 81 is fixed to the vicinity of a right end portion of an upper surface of the fixed disk 70 with an appropriate fastening member (a bolt or the like). The right portion 81c of the first restricting member 81 is disposed to protrude rightward from the fixed disk 70. A cutout portion 81d is formed in the right portion 81c.

The second restricting member 82 engages with the first restricting member 81. The second restricting member 82 is formed in a substantially columnar shape. The second restricting member 82 is arranged with its axis oriented in the vertical direction (the up-and-down direction). An upper end portion of the second restricting member 82 is fixed to the upper surface of the film forming chamber 2 via the bracket 82a. The second restricting member 82 engages with the cutout portion 81d of the first restricting member 81 provided on each fixed disk 70. More specifically, the second restricting member 82 is fitted to the cutout portion 81d of the first restricting member 81, and the rotation of the fixed disk 70 is regulated.

In this way, the rotation of the fixed disk 70 is restricted by the first restricting member 81 provided on the fixed disk 70 engaging with the second restricting member 82 fixed to the film forming chamber 2. As a result, even if the rotating shaft 20 rotates, the fixed disk 70 does not rotate.

The cover 90 shown in Figs. 3 to 5 covers the workpiece retaining part 60. The cover 90 is formed by a plate-shaped member being appropriately bent. The cover 90 is arranged to cover the workpiece retaining part 60 from a lateral side (an outer side in the radial direction of the fixed disk 70) and from above. A through hole 91 is formed in the cover 90. The workpiece W retained by the workpiece retaining part 60 can be exposed to the outside of the cover 90 through the through hole 91. The cover 90 is fixed to the rotating wheel 40 in an appropriate manner.

Next, an aspect in which the unit for rotating a workpiece retaining part 3 is operated with the power of the motor 4 will be described.

When the motor 4 is driven, the rotating shaft 20 is rotated with the power of the motor 4. The rotating wheel 40 rotates integrally with the rotating shaft 20. As a result, the workpiece retaining part 60 provided on the outer peripheral portion 43 of the rotating wheel 40 rotates (revolves) about the rotating shaft 20.

On the other hand, the rotation of the fixed disk 70 provided to be relatively rotatable with respect to the rotating shaft 20 is restricted by the restricting part 80. Therefore, the fixed disk 70 does not rotate along with the rotation of the rotating shaft 20.

The rotationally driven part 62 of the workpiece retaining part 60 rotates (revolves) about the rotating shaft 20 while being in contact with the fixed disk 70 which is fixed (does not rotate). As a result, the workpiece retaining part 60 rotates (on its axis) about the axis of the workpiece retaining part 60 while rotating (revolving) about the rotating shaft 20 (see Fig. 2).

Further, in a case in which the workpiece retaining part 60 rotates (revolves) about the rotating shaft 20, an inclination angle α of the workpiece retaining part 60 seen in a direction from the outside of the workpiece retaining part 60 toward the rotating shaft 20 (in other words, as shown in Figs. 4 and 5, in a cross-sectional view that passes through the rotating shaft 20 and is parallel to the rotating shaft 20) is always constant. The inclination angle α is an angle of the workpiece retaining part 60 with respect to the axis of the rotating shaft 20 or the plate surface of the target 6 in the cross section shown in Figs. 4 and 5 (the cross section seen in the circumferential direction of a virtual circle centered on the rotating shaft 20). In the present embodiment, since the axis of the rotating shaft 20 and the plate surface of the target 6 are parallel to the up-and-down direction (the vertical direction), the inclination angle α is an angle of the workpiece retaining part 60 with respect to a virtual line X in the up-and-down direction (the vertical direction) in the cross section shown in Figs. 4 and 5. The cross section seen in the circumferential direction of the virtual circle centered on the rotating shaft 20 can also be expressed as a cross section seen on a periphery of the virtual circle centered on the rotating shaft 20.

Therefore, in a film formation region in which, when the workpiece retaining part 60 rotates (revolves) about the rotating shaft 20, particles of the film forming material from the target 6 collide with the workpiece W at a position where the work W faces the target 6, and a relatively thick film is formed, the inclination angle α of the workpiece retaining part 60 (the workpiece W) with respect to the target 6 becomes substantially constant. Further, at this time, since workpiece W rotates on its axis about the axis of the workpiece retaining part 60, it is possible to make a film quality of the film formed on the entire exposed surface of the workpiece W uniform.

Next, a method (a sputtering method) for manufacturing a film-formed product using the sputtering device 1 configured as described above will be described.

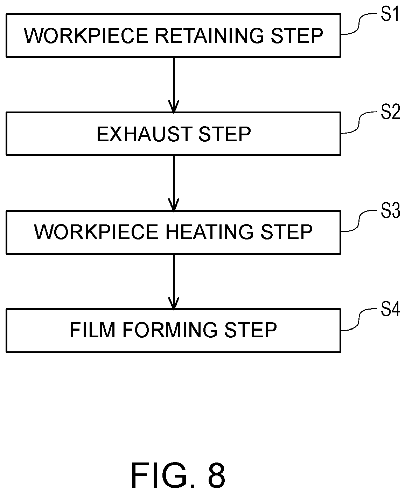

As shown in Fig. 8, the method for manufacturing a film-formed product according to the present embodiment mainly includes a workpiece retaining step S1, an exhaust step S2, a workpiece heating step S3, and a film forming step S4.

The workpiece retaining step S1 is a step of causing the workpiece retaining part 60 to retain the workpiece W. In the workpiece retaining step S1, an operator inserts the workpiece W into the retaining part 61a of the workpiece retaining part 60, and the workpiece W is retained by the workpiece retaining part 60.

The exhaust step S2 is a step of discharging the air in the film forming chamber 2. In the exhaust step S2, when the exhaust device 5 is operated, the air in the film forming chamber 2 is discharged. By the exhaust device 5 being appropriately controlled, the inside of the film forming chamber 2 is adjusted such that a degree of vacuum is suitable for the film forming processing.

The workpiece heating step S3 is a step of heating the workpiece W. In the workpiece heating step S3, when the motor 4 is driven, the unit for rotating a workpiece retaining part 3 is operated, and the rotation (the revolution and the rotation on its axis) of the workpiece retaining part 60 is started. Further, in the workpiece heating step S3, the heater 7 is operated, and the workpiece W retained by the workpiece retaining part 60 is heated to an appropriate temperature.

The film forming step S4 is a step of executing film forming processing to the workpiece W. In the film forming step S4, the unit for rotating a workpiece retaining part 3 is continuously operated. Further, in the film forming step S4, a sputtering gas (for example, an inert gas such as Ar) is supplied into the film forming chamber 2. In this state, a negative voltage or a high frequency (a radio frequency: RF) voltage is applied to the target 6 to generate a glow discharge. As a result, the sputtering gas is ionized and the ions collide with a surface of the target 6 at high speed to begin to strike the particles (particles to be sputtered) of the film forming material constituting the target 6. The particles of the film forming material separated from the target 6 adhere to a surface of the workpiece W. It is possible to form a thin film by depositing these particles on the surface of the workpiece W. In this way, it is possible to manufacture a workpiece W (a film-formed product) subjected to the film forming processing.

In the present embodiment, for convenience, the workpiece retaining step S1, the exhaust step S2, the workpiece heating step S3, and the film forming step S4 have been described in order, but the method for manufacturing a film-formed product is not necessarily limited to this. For example, the order of some steps can be changed (for example, the order of the exhaust step S2 and the workpiece heating step S3 can be changed), or the steps can be performed at the same time (for example, the exhaust step S2 and the workpiece heating step S3 can be performed at the same time).

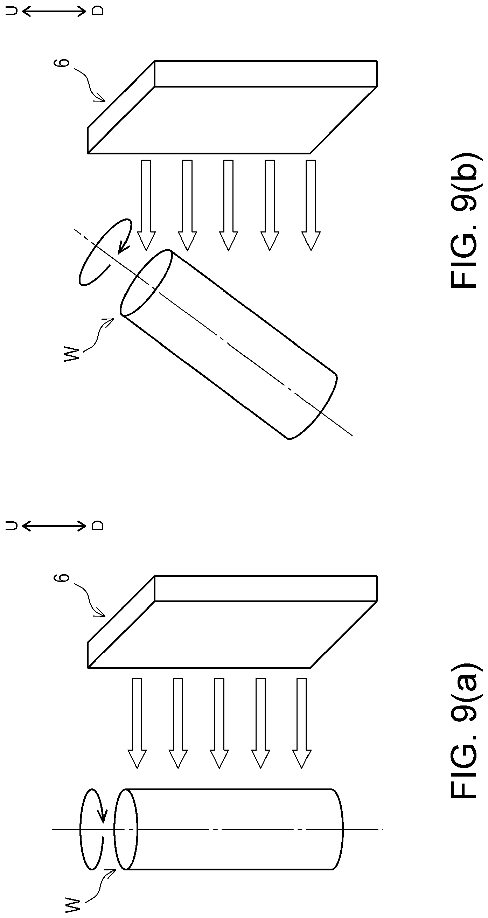

Here, with reference to Fig. 9, it will be described how the method for manufacturing a film-formed product using the sputtering device 1 suppresses occurrence of unevenness of the thin film formed on the workpiece W. In Fig. 9, for convenience of explanation, a shape of the workpiece W is simplified and the workpiece W is shown as a columnar shape.

As a comparative example, as shown in Fig. 9(a), it is assumed that the workpiece W is not inclined and rotates on its axis about an axis oriented in the vertical direction. In this case, since the workpiece W is rotating on its axis, the entire side surface of the workpiece W faces the target 6 arranged on a lateral side of the workpiece W. As a result, the particles of the film forming material from the target 6 can be adhered to the entire side surface of the workpiece W.

On the other hand, even if the workpiece W rotates on its axis, an upper surface of the workpiece W does not face the target 6, and thus the particles of the film forming material from the target 6 are unlikely to adhere to the upper surface of the workpiece W. That is, the formed thin film may be uneven between the side surface and the upper surface of the workpiece W.

In particular, in the film forming processing by sputtering (a sputtering method), there is a difference in a compressive stress (an internal stress) of the formed thin film between the side surface and the upper surface of the workpiece W, and this difference in the compressive stress may reduce an adhesion and a homogeneity of the thin film.

On the other hand, in the present embodiment, as shown in Fig. 9(b), the workpiece W is configured to rotate on an axis inclined with respect to the target 6. In this case, not only the side surface of the workpiece W but also the upper surface thereof can face the target 6. Therefore, it is possible to prevent the formed thin film from becoming uneven between the side surface and the upper surface of the workpiece W. Further, it is possible to suppress a difference in the compressive stress of the thin film between the side surface and the upper surface of the workpiece W, and it is possible to improve the adhesion and the homogeneity of the thin film.

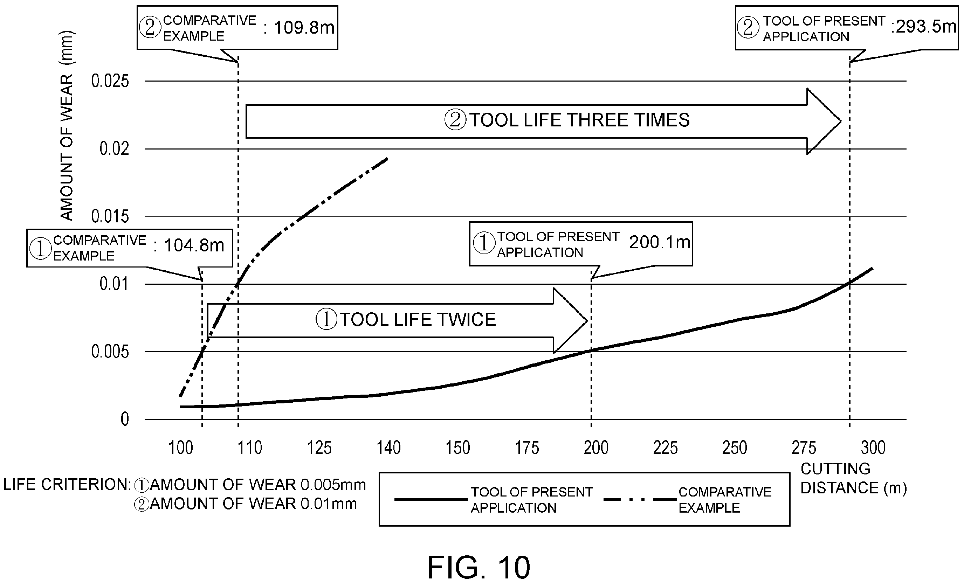

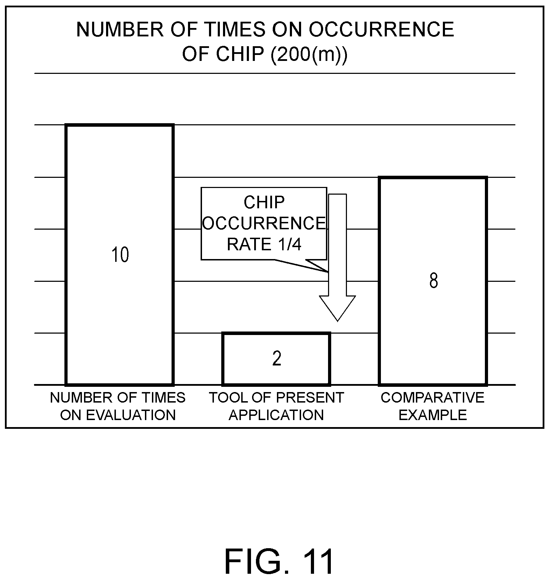

Hereinafter, an example of evaluation of a tool on which a film is formed by the sputtering device 1 (the method for manufacturing a film-formed product) according to the present embodiment will be described with reference to Figs. 10 and 11.

Fig. 10 shows an example of evaluation regarding a life between a tool on which a film is formed by the sputtering device 1 according to the present embodiment (hereinafter referred to as a "tool of the present application") and a tool on which a film is formed by a known method in the related art as a comparative example (hereinafter referred to as a "comparative example").

Here, in a state in which, as sputtering conditions in the present embodiment, an RF sputtering method using an RF power supply is used, and an AlCr-based alloy is used as the sputtering target, a film is formed by reactive sputtering with a mixed gas, as a sputtering gas, in which a nitrogen gas is contained in an argon gas.

The tool to be evaluated is "R 0.5 cemented carbide ball end mill." This tool is a "superhard material (cemented carbide)" whose base material is a WC-Co alloy and on which an AlCrN-based film is formed (coated).

In addition, as an evaluation test, cutting was performed using the above two types of tools. A type of a material to be cut (a cutting target material type) is SUS420J2 (HRC55). Cutting conditions are a rotation speed: 30,000 (min⁻¹), a feed rate: 1,500 (mm/min), and a depth of cut Rd (XY): 0.05 (mm).

In addition, as a criterion of a life (an amount of wear of the tool for determining a life of the tool) at the time of the evaluation, two patterns of criteria were set as (A): amount of wear 0.005 (mm) and (B): amount of wear 0.01 (mm). In Fig. 10, a horizontal axis shows a cutting distance, and a vertical axis shows the amount of wear.

As shown in Fig. 10, in a case in which the life criterion is (A): amount of wear 0.005 (mm), the life of the comparative example is 104.8 (m), whereas the life of the tool of the present application is 200.1 (m). That is, in a case in which the life criterion is (A): amount of wear 0.005 (mm), it can be seen that the life of the tool of the present application is about twice as compared with that of the comparative example.

Further, in a case in which the life criterion is (B): amount of wear 0.01 (mm), the life of the comparative example is 109.8 (m), whereas the life of the tool of the present application is 293.5 (m). That is, in a case in which the life criterion is (B): amount of wear 0.01 (mm), it can be seen that the life of the tool of the present application is about three times as compared with that of the comparative example.

Fig. 11 shows an example of evaluation regarding occurrence of a chip between the tool of the present application and a comparative example.

As the evaluation regarding the occurrence of the chip, the number of times on the occurrence of the chip in the tool was compared in a case in which cutting of 200 (m) was performed under the same conditions as the example shown in Fig. 10. The number of times on the evaluation (the number of times on the cutting) was 10, and the tool was observed at a magnification of 20 times using a factory microscope after cutting. In a case in which the chip was confirmed regardless of the size of the chip, it was counted as the occurrence of the chip.

As a result, as shown in Fig. 11, in the comparative example, the occurrence of the chip was confirmed in 8 out of 10 in the number of times on the evaluation. On the other hand, in the tool of the present application, the occurrence of the chip was confirmed in only 2 out of 10 in the number of times on the evaluation. That is, it can be seen that an occurrence rate of the chip of the tool of the present application is one-fourth of that of the comparative example.

As described above, it could be seen that the tool on which a film is formed by the sputtering device 1 (the method for manufacturing a film-formed product) according to the present embodiment has a long life and suppresses the occurrence of the chip by the improvement of the adhesion and the homogeneity of the thin film (a coating).

In the present embodiment, the device (the sputtering device 1) that performs sputtering is exemplified as an example of the vacuum processing device (the vacuum film forming device), but the present invention is not limited to this and can be applied to various other vacuum processing. For example, the present invention can be widely applied to a physical vapor phase growth method (physical vapor deposition: PVD) that utilizes physical motion of particles, a chemical vapor phase growth method (chemical vapor deposition: CVD) that utilizes a chemical reaction, and the like. In particular, in the film forming device, the present invention is effective in a case in which there is an angle dependency as the film quality varies with respect to the angle at which the film forming material reaches the workpiece.

In the PVD, an evaporation system in which a vapor deposition source is heated and evaporated to form a film includes vacuum vapor deposition, molecular beam deposition, ion plating, ion beam deposition, plasma laser deposition (PLD), and the like. Further, a sputtering system as illustrated in the present embodiment includes conventional sputtering, magnetron sputtering, ion beam sputtering, ECR sputtering, reactive sputtering (in which reactive gas (O₂, N₂, and the like) is introduced and a film is formed on an oxide or nitride), and the like. Further, depending on the material of the workpiece W, it is also possible to use RF sputtering using a radio frequency (RF) power supply.

Further, the CVD includes conventional CVD, thermal CVD, optical CVD, plasma CVD, epitaxial CVD, MOCVD, and the like.

Further, as the thin film which is formed on the workpiece W according to the present embodiment, a thin film which particularly includes at least one of AlCrN, AlN, TiCrN, TiN, TiAIN, TiAlCrN, and Al₂O₃ and is constituted by a single layer or a plurality of stacked layers is assumed, but it is also possible to form any other thin film.

Further, in addition to the above-mentioned film forming material, it is also possible to add an additive as appropriate. For example, Nb, Ta, Mo, V, Y, Si, or the like can be added as the additive.

Further, the present invention can be applied to a plasma processing device such as a dry etching device and a surface modification device in addition to the film forming device as the vacuum processing device. In such a plasma processing device, processing characteristics or processing performance may vary depending on an angle at which plasma reaches the workpiece, and the present invention is effective in such a case.

As described above, the method for producing a film-formed product according to the present embodiment includes
the workpiece retaining step S1 of retaining the workpiece W such that the workpiece W can revolve about a first rotating shaft (the rotating shaft 20) and can rotate on its axis about a second rotating shaft (the workpiece retaining part 60) inclined with respect to the target 6 (the sputtering target), and
the film forming step S4 of performing film forming on the workpiece W using the target 6 while the workpiece W revolves about the first rotating shaft and rotates on the second rotating shaft.

With such a configuration, it is possible to suppress the occurrence of unevenness of the thin film formed on the workpiece W. For example, as in the present embodiment, by enabling the workpiece retaining part 60 to rotate (on its axis) about an axis inclined with respect to the target 6, it is possible to easily perform the film forming processing not only on the side surface of the workpiece W but also on the upper surface thereof. Accordingly, it is possible to suppress the occurrence of unevenness of the formed thin film, and it is possible to improve the adhesion and the homogeneity of the thin film (the coating).

Further, in the workpiece retaining step S1, the workpiece W is retained such that the inclination angle α with respect to the target 6 in a state in which the workpiece W faces the target 6 is constant.

With such a configuration, the plurality of workpiece retaining parts 60 is subjected to the film forming processing in a state in which the workpiece retaining part 60 is inclined at a constant angle with respect to the target 6 arranged on the outside of the rotating wheel 40 in the radial direction. As a result, it is possible to suppress the occurrence of dependency on an angle of a processing surface of the workpiece W (defects such as unevenness due to a change in the inclination angle α).

Further, in the film forming step S4, film forming is performed on the workpiece W using high frequency sputtering.

With such a configuration, a film quality of the formed film can be improved.

Further, in the film forming step S4, the film is formed on the workpiece using reactive sputtering.

With such a configuration, a product (for example, oxide, nitride, or the like) of the reactive gas and constituent substance of the target 6 can be formed as a thin film.

Further, in the workpiece retaining step S1, a machining tool is used as the workpiece W.

With such a configuration, it is possible to suitably perform the film forming processing even on a machining tool having a complicated shape.

Further, in the film forming step S4, a film which includes at least one of AlCrN, AlN, TiCrN, TiN, TiAIN, TiAlCrN, and Al₂O₃ and is constituted by a single layer or a plurality of stacked layers is formed on the workpiece W.

With such a configuration, a hard film can be formed on the workpiece W to improve wear resistance, heat resistance, and the like.

Further, in the film forming step S4, in a state where the workpiece W faces the target 6 due to revolution about the first rotating shaft, the workpiece W is continuously rotated on its axis about the second rotating shaft.

With such a configuration, the homogeneity of the thin film (the coating) can be improved.

Further, the sputtering device 1 according to the present embodiment includes
the rotating shaft 20;
the target 6 (the sputtering target) arranged on a lateral side of the rotating shaft 20;
the rotating wheel 40 (the rotating part) capable of rotating about the rotating shaft 20;
the plurality of workpiece retaining parts 60 which is capable of retaining the workpiece W, is arranged to be aligned on the periphery centered on the rotating shaft 20, and is provided on the rotating wheel 40 to be able to rotate about an axis inclined with respect to the target 6; and
the fixed disk 70 (rotationally driving part) which is formed in a disk shape centered on the rotating shaft 20, is arranged in contact with the plurality of workpiece retaining parts 60, and causes the workpiece retaining parts 60 to rotate in accordance with rotation of the rotating wheel 40.

With such a configuration, it is possible to suppress the occurrence of unevenness of the thin film formed on the workpiece W by performing the film forming processing on the workpiece W using the target 6 while rotating the workpiece retaining part 60. For example, as in the present embodiment, by enabling the workpiece retaining part 60 to rotate (on its axis) about an axis inclined with respect to the target 6, it is possible to easily perform the film forming processing not only on the side surface of the workpiece W but also on the upper surface thereof. Accordingly, it is possible to suppress the occurrence of unevenness of the formed thin film, and it is possible to improve the adhesion and the homogeneity of the thin film (the coating).

Further, the method for producing a film-formed product according to the present embodiment is to manufacture a film-formed product using the sputtering device 1.

Withe such as configuration, it is possible to suppress the occurrence of unevenness of the formed thin film, and it is possible to improve the adhesion and the homogeneity of the thin film (the coating).

Further, the unit for rotating a workpiece retaining part 3 according to the present embodiment includes
the rotating shaft 20;
the rotating wheel 40 (the rotating part) capable of rotating about the rotating shaft 20;
the plurality of workpiece retaining parts 60 which is capable of retaining the workpiece W, is arranged to be aligned on the periphery centered on the rotating shaft 20, and is provided on the rotating wheel 40 to be able to rotate about an axis inclined with respect to the rotating shaft 20; and
the fixed disk 70 (rotationally driving part) which is formed in a disk shape centered on the rotating shaft 20, is arranged in contact with the plurality of workpiece retaining parts 60, and causes the workpiece retaining parts 60 to rotate in accordance with rotation of the rotating wheel 40.

With such a configuration, in a case in which this configuration is applied to the film forming device, it is possible to suppress the occurrence of unevenness of the thin film formed on the workpiece W by performing the film forming processing on the workpiece W while rotating the workpiece retaining part 60. For example, as in the present embodiment, by enabling the workpiece retaining part 60 to rotate (on its axis) about an axis inclined with respect to the rotating shaft 20, it is possible to easily perform the film forming processing not only on the side surface of the workpiece W but also on the upper surface thereof. Accordingly, it is possible to suppress the occurrence of unevenness of the formed thin film, and it is possible to improve the adhesion and the homogeneity of the thin film (the coating). Further, in a case in which this configuration is applied to the plasma processing device other than the film forming device, it is possible to stabilize the processing characteristics or the processing performance with respect to the dependency on the angle at which the plasma reaches the workpiece.

In particular, in the present embodiment, it is configured that the plurality of work holding portions 60 is rotated (on their axes) by the disk-shaped fixed disk 70 which is in contact with the plurality of workpiece retaining parts 60. In such a configuration, the plurality of workpiece retaining parts 60 rotates on their axes and revolves while maintaining a posture inclined outward in the radial direction of the rotating wheel 40 at a constant angle. That is, in a case in which this configuration is applied to the sputtering device, the plurality of workpiece retaining parts 60 is subjected to the film forming processing in a state in which the workpiece retaining part 60 is inclined at a constant angle with respect to the target 6 arranged on the outside of the rotating wheel 40 in the radial direction. As a result, it is possible to suppress the occurrence of dependency on an angle of a processing surface of the workpiece W (defects such as unevenness due to a change in the inclination angle α).

Further, the rotating shaft 20 is formed to be able to rotate using power from the motor 4 (a power source),
the rotating wheel 40 is provided on the rotating shaft 20 to be able to rotate integrally with the rotating shaft 20,
the fixed disk 70 is provided to be able to rotate relative to the rotating shaft 20, and
the restricting part 80 that restricts rotation of the fixed disk 70 is further provided.

With such a configuration, by fixing the fixed disk 70 (restricting the rotation), it is possible for the rotating wheel 40 and the fixed disk 70 to rotate relatively, and it is possible to rotate (on its axis) the workpiece retaining part 60 by this relative rotation. Further, by restricting the rotation of the fixed disk 70 by the restricting part 80, it is possible to prevent the fixed disk 70 from rotating together with the rotating shaft 20, and it is possible to rotate the workpiece retaining part 60 at a stable speed (a constant speed).

Further, a plurality of the rotating wheels 40, a plurality of the workpiece retaining parts 60 provided on the rotating wheel 40, and a plurality of the fixed disks 70 which causes the workpiece retaining part 60 to rotate are provided in an axial direction of the rotating shaft 20.

With such a configuration, a large number of workpieces W can be rotated at once, and the efficiency of the film forming processing can be improved.

Further, the workpiece retaining part 60 includes
the rotation support part 61 which retains the workpiece W and is rotatably supported by the rotating wheel 40, and
the rotationally driven part 62 which is fixed to the rotation support part 61 and is arranged in contact with the fixed disk 70.

With such a configuration, it is possible to suppress the complication of the shape of each component by forming the rotation support part 61 and the rotationally driven part 62 as separate members.

Further, the rotation support part 61 is rotatably supported by the rotating wheel 40 via the bearing member 61c.

With such a configuration, the workpiece retaining part 60 can be smoothly rotated. As a result, a driving force required for the rotation of the workpiece retaining part 60 can be reduced.

Further, the rotation support part 61 is arranged such that a lower portion thereof is inserted into the rotating wheel 40 and an upper portion thereof protrudes upward from the rotating wheel 40, and
the rotationally driven part 62 is provided on the rotation support part 61 above the rotating wheel 40.

With such a configuration, it is possible to arrange a mechanism (the rotationally driven part 62) for rotating (on its axis) the workpiece retaining part 60 at a relatively high position (above the rotating wheel 40), and it is possible to improve maintainability of this mechanism.

Further, the sputtering device 1 (the vacuum processing device) according to the present embodiment includes the unit for rotating a workpiece retaining part 3.

With such a configuration, it is possible to suppress the occurrence of unevenness of the thin film formed on the workpiece W by performing the film forming processing on the workpiece W while rotating the workpiece retaining part 60.

The rotating wheel 40 according to the present embodiment is an embodiment of the rotating part.

Further, the fixed disk 70 according to the present embodiment is an embodiment of the rotationally driving part.

Further, the target 6 according to the present embodiment is an embodiment of the sputtering target.

Further, the motor 4 according to the present embodiment is an embodiment of the power source.

Further, each of the rotating shaft 20 and the workpiece retaining part 60 according to the present embodiment is an embodiment of each of the first rotating shaft and the second rotating shaft.

Further, the sputtering device 1 according to the present embodiment is an embodiment of the vacuum processing device.

Although one embodiment of the present invention has been described above, the present invention is not limited to the above embodiment and can be appropriately modified within the scope of the technical idea of the invention described in the claims.

For example, in the present embodiment, a machining tool (a tool for machining such as cutting, grinding, and polishing) is exemplified as an example of the workpiece W, but the present invention is not limited to this. That is, the workpiece W on which a film is formed can be arbitrarily selected. For example, as other examples of the workpiece W, various articles such as punch parts (blades for punching), die parts for die casting, and cutter blades are assumed.

Further, the shape of the workpiece W is not limited, and any shape can be used. For example, not only rod-shaped, columnar, and prismatic members extending long in one direction, but also members having a complicated three-dimensional shape may be used. Further, a member having a complicated surface shape (for example, a cutting edge of a tool or the like) can be used as the workpiece W.

Further, in the present embodiment, the workpiece W is retained in an inclined state with respect to the rotating shaft 20 or the target 6, but the angle and direction of the inclination can be arbitrarily changed. For example, by replacing the rotating wheel 40 with another rotating wheel 40 having a different inclination angle of the through hole 43b, it is possible to change the inclination angle α of the workpiece retaining part 60 (eventually, the inclination angle α of the workpiece W). Further, by replacing not only the rotating wheel 40 but also other members (for example, the attachment member 50), it is possible to change the inclination angle α of the workpiece W.

Further, in the present embodiment, an aspect in which two sets each constituted by the rotating wheel 40, the workpiece retaining part 60 provided on the rotating wheel 40, and the fixed disk 70 corresponding to the workpiece retaining part 60 are arranged side by side (in two stages) vertically has been illustrated and described, but the number of the rotating wheels 40 and the like is not limited. That is, it is possible to provide the rotating wheel 40 and the like by only one set or by three or more sets in the sputtering device 1.

In the present embodiment, one set of the rotating wheel 40 and the like is arranged not to overlap another set of the rotating wheel 40 and the like that is vertically adjacent to the one set of the rotating wheel 40 and the like as seen from the lateral side. For example, as shown in Fig. 4, one set of the rotating wheel 40, the workpiece retaining part 60, and the fixed disk 70 which are provided on a lower side (a lower stage) is arranged to be located below another set of the rotating wheel 40 and the like provided on an upper side (an upper stage). In this way, by arranging both such that they do not overlap as seen from the lateral side, maintainability from the lateral side can be improved.

Further, in the present embodiment, the configuration in which the target 6 and the heater 7 are arranged around the unit for rotating a workpiece retaining part 3 is illustrated, but the present invention is not limited to this. For example, it is also possible to further provide an ion gun to perform pretreatment (for example, to remove oxides on the surface of the workpiece W by striking the oxides with argon ions). Further, depending on the type of the workpiece W and the like, it is possible to perform the film forming processing without using the heater 7.

Further, in the present embodiment, the motor 4 is exemplified as an example of the power source, but the present invention is not limited to this. That is, it is also possible to use other power sources (an engine, an actuator, and the like).

Further, a speed (a rotation speed) of the rotation (revolution and rotation on its axis) of the workpiece retaining part 60 can be appropriately set. For example, the speed is set such that the workpiece retaining part 60 rotates on its axis at least one rotation (360°) or more while the workpiece retaining part 60 is passing through a front surface of the target 6 (while the workpiece retaining part 60 is facing the target 6) with the rotation (the revolution) about the rotating shaft 20. As a result, the film forming material from the target 6 can be adhered to the entire region of the workpiece W, and the adhesion and the homogeneity of the thin film can be further improved.

### [Reference Signs List]

- 1: Sputtering device
- 4: Motor
- 6: Target
- 20: Rotating shaft
- 40: Rotating wheel
- 60: Workpiece retaining part

- 61: Rotation support part
- 62: Rotationally driven part
- 70: Fixed disk
- 80: Restricting part

## Claims

1. A unit for rotating a workpiece retaining part comprising
a rotating shaft;
a rotating part capable of rotating about the rotating shaft;
a plurality of workpiece retaining parts which is capable of retaining a workpiece, is arranged to be aligned on a periphery centered on the rotating shaft, and is provided on the rotating part to be able to rotate about an axis inclined with respect to an axis of the rotating shaft; and
a rotationally driving part which is formed in a disk shape centered on the rotating shaft, is arranged in contact with the plurality of workpiece retaining parts, and causes the workpiece retaining parts to rotate in accordance with rotation of the rotating part.

2. The unit for rotating a workpiece retaining part according to claim 1,
wherein the rotating shaft is formed to be able to rotate using power from a power source,
wherein the rotating part is provided on the rotating shaft to be able to rotate integrally with the rotating shaft,
wherein the rotationally driving part is provided to be able to rotate relative to the rotating shaft, and
wherein the unit for rotating a workpiece retaining part further comprises a restricting part that restricts rotation of the rotationally driving part.

3. The unit for rotating a workpiece retaining part according to claim 1 or 2, wherein a plurality of the rotating parts, a plurality of the workpiece retaining parts provided on the rotating part, and a plurality of the rotationally driving parts which causes the workpiece retaining part to rotate are provided in an axial direction of the rotating shaft.

4. The unit for rotating a workpiece retaining part according to any one of claims 1 to 3, wherein the workpiece retaining part comprises
a rotation support part which retains the workpiece and is rotatably supported by the rotating part, and
a rotationally driven part which is fixed to the rotation support part and is arranged in contact with the rotationally driving part.

5. The unit for rotating a workpiece retaining part according to claim 4, wherein the rotation support part is rotatably supported by the rotating part via a bearing member.

6. The unit for rotating a workpiece retaining part according to claim 4 or 5,
wherein the rotation support part is arranged such that a lower portion thereof is inserted into the rotating part and an upper portion thereof protrudes upward from the rotating part, and
wherein the rotationally driven part is provided on the rotation support part above the rotating part.

7. A vacuum processing device comprising the unit for rotating a workpiece retaining part according to any one of claims 1 to 6.
